# EUROPÄISCHE PATENTSCHRIFT

(11) **EP 2 803 633 B1**
(45) Veröffentlichungstag und Bekanntmachung des Hinweises auf die Patenterteilung: **19.08.2015**
(21) Anmeldenummer: 14168396.1
(22) Anmeldetag: 15.05.2014
(51) Int. Cl.: B81B 3/00

(54) **Vorrichtung mit einem schwingfähig aufgehängten optischen Element**
Device with a suspended pivoting optical element
Dispositif doté d'un élément optique suspendu pivotant

(30) Priorität: 17.05.2013 DE 102013209234
(43) Veröffentlichungstag der Anmeldung: 19.11.2014
(73) Patentinhaber: Fraunhofer-Gesellschaft zur Förderung der angewandten Forschung e.V., 80686 München (DE)
(72) Erfinder: Gu-Stoppel, Shanshan, 25524 Itzehoe (DE); Quenzer, Hans Joachim, 25524 Itzehoe (DE); Janes, Joachim, 25524 Itzhoe (DE)
(74) Vertreter: Schenk, Markus

(56) Entgegenhaltungen:
- EP-A1- 2 233 961
- US-B1- 6 657 764

## Beschreibung

Beim Betrieb von Mikrospiegeln, darunter auch in Resonanz betriebene piezoelektrische Mikrospiegel, liegt die Aufgabe meist darin, sowohl eine hohe Resonanzfrequenz als auch eine große Auslenkung des Mikrospiegels umzusetzen. Eine hohe Resonanzfrequenz in Kombination mit einer großen Auslenkung des Mikrospiegels ist jedoch gleichzeitig nur schwer erreichbar. So ist mit einem in US 7,190,502 B2 eine Vorrichtung beschrieben, mit der eine Auslenkung von 12,4 mm bei einer Resonanzfrequenz von 10,6 kHz erzielbar ist. US 8,125,699 B2 zeigt Vorrichtungen, mit der eine Amplitude von 5,25 mm bei einer Resonanzfrequenz von 15,6 kHz respektive 9 mm bei einer Resonanzfrequenz von 304 Hz erzielbar ist. Vorrichtungen aus US 6,657,764 B1 können mit Amplituden von 40 mm bei einer Resonanzfrequenz von 500 Hz respektive mit einer Amplitude von 3,9 mm bei einer Resonanzfrequenz von 17,2 kHz betrieben werden.

Um gleichzeitig große Auslenkungen und hohe Resonanzfrequenzen zu erhalten, wird in EP 2233 961 A1 ein Aufbau offenbart, in welchem ein schwingfähiges, oszillierendes System seitlich angeordnete Aktuatoren und einen mittig angeordneten Mikrospiegel umfasst, die, über eine Torsionsfeder mit einander verbunden, ein schwingfähiges Gesamtsystems bilden und eine gemeinsame Resonanzfrequenz aufweisen. Um eine hohe Betriebsfrequenz zu ermöglichen, werden die Aktuatoren in der "one-node-mode", der Frequenz der zweiten Eigenmode eines Biegebalkens, angetrieben. Hierfür wird eine geringe Schichtdicke der Aktuatoren benötigt, was die mechanische Stabilität der Struktur empfindlich gegenüber mechanischen Beschädigungen und Dauerbelastungen werden lässt Gleichzeitig weist das Gesamtsystem eine sehr hahe an der "one-node-mode" liegende parasitäre und im Betrieb unerwünschte Mode auf, was den Betrieb der in EP 2233 961 A1 vorgestellten Vorrichtung erschwert.

Fig. 12 zeigt eine Figur aus EP 2233 961 A1.

In US 6,198,565 B1 wird eine Umsetzungsmöglichkeit resonant betriebener Mikrospiegel vorgeschlagen, mit der hohe Auslenkungen, hohe Resonanzfrequenzen und klar von anderen Moden getrennte Betriebsmoden erreicht werden können. Nachteilig an dieser Lösung ist jedoch, dass die den Mikrospiegel mit den Aktuatoren verbindenden Federn mit hohen mechanischen Spannungen beaufschlagt werden, so dass bereits bei moderaten Spiegelauslenkungen Materialbeanspruchungen erreicht werden, die zu einem Materialversagen der Federn führen, so dass die Federn brechen.

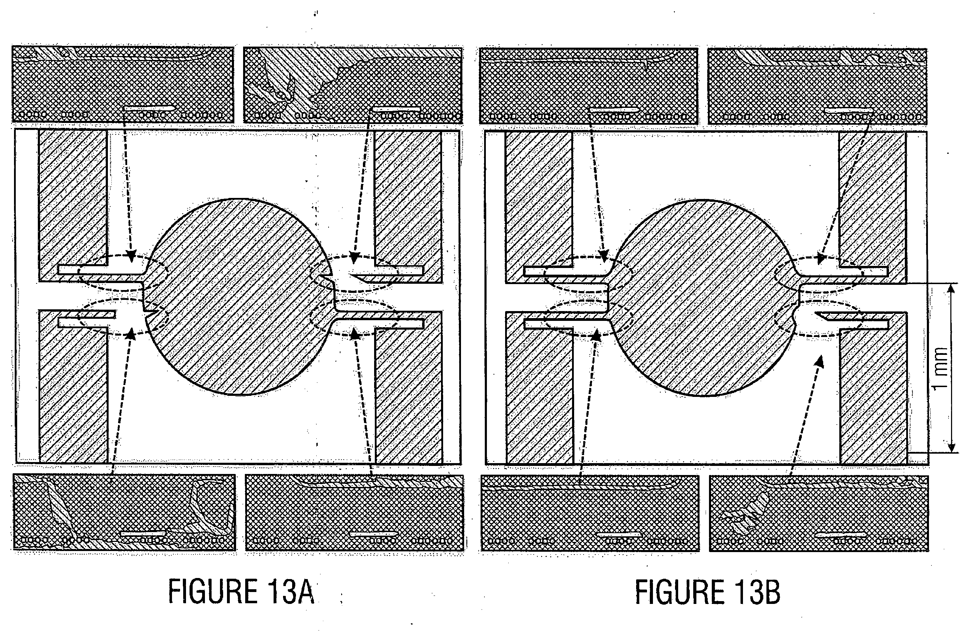

Die Figuren 13a und 13b zeigen Aufnahmen eines solchen Mikrospiegels, dessen Federelemente Defekte aufweisen.

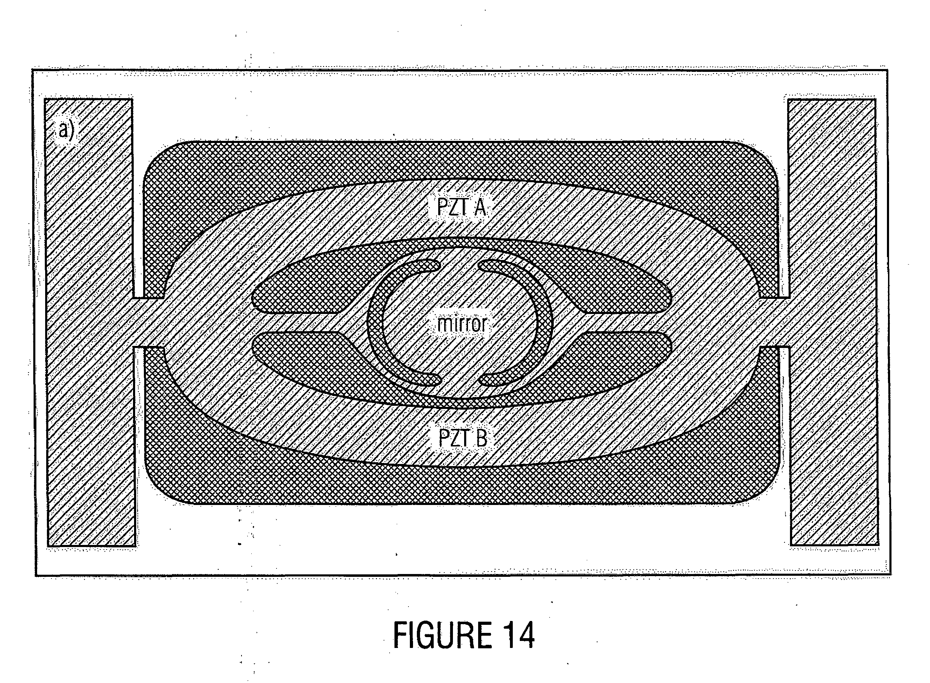

In der Veröffentlichung "High Frequency Torsional MEMS Scanner for Displays" hat U. Baran et al. mit einem in Fig. 14 vorgestellten Design einen optischen Scanwinkel des Mikrospiegels von 38,5° bei einer Resonanzfrequenz von 39,5 kHz erreicht.

Bei diesem Design wird ein kaskadisches Oszillatorsystem aus mehreren Schwingungsrahmen konstruiert. Die Schwingungsrahmen werden dabei aus den piezoelektrischen Aktuatoren gebildet, die wiederum mit dem mittig angeordneten Mikrospiegel und einem äußeren Rahmen jeweils über breite Torsionsfedern verbunden sind. Damit wird eine Überbelastung des Materials vermieden und gleichzeitig ein großer Scanwinkel und damit eine hohe Amplitude sowie eine hohe Resonanzfrequenz ermöglicht. Nachteilig an dieser Lösung ist zum einen ein erhöhter Bauraumbedarf, da die Abmessungen der einzelnen Komponenten aufgrund der Ausbildung eines doppelten Rahmens und der großen Breite der Federn entsprechend groß sind, sowie eine relativ niedrige Energieeffizienz des Aufbaus, da jeweils beide Enden der piezoelektrischen Aktuatoren beweglich gelagert sind, so dass die durch die Aktuatoren erzeugte Kraft nicht vollständig auf den Mikrospiegel respektive die Torsionsfedern übertragen werden kann.

Wünschenswert wäre demnach ein Konzept zur Aufhängung eines Mikrospiegels, welches sowohl hohe Amplituden und Scanwinkel als auch hohe Resonanzfrequenzen ermöglicht.

Die Aufgabe der vorliegenden Erfindung besteht deshalb darin, eine Vorrichtung mit einem schwingfähig aufgehängten optischen Element zu schaffen, so dass hohe Materialbelastungen vermieden werden und eine höhere Resonanzfrequenz des optischen Elements ermöglicht wird, wobei gleichzeitig ein energieeffizienter Betrieb der Vorrichtung durch einen optimalen Kraftfluss ermöglicht wird.

Diese Aufgabe wird durch den Gegenstand der unabhängigen Patentansprüche gelöst.

Der Kerngedanke der vorliegenden Erfindung besteht darin, erkannt zu haben, dass obige Aufgabe dadurch gelöst werden kann, dass jeweils einseitig fest gelagerte Aktuatoren über gekrümmte Federelemente mit dem schwingfähig aufgehängten Mikrospiegel verbunden sind. Die gekrümmten Federelemente erlauben eine Aufnahme von Kräften derart, dass ein Materialversagen trotz hoher Betriebsfrequenzen und Auslenkungsamplituden verhindert ist.

Gemäß einem Ausführungsbeispiel ist ein schwingfähig aufgehängter Mikrospiegel über vier Torsionsfedern an zwei Aktuatoren aufgehängt, wobei die Torsionsfedern mehrfach gekrümmt und mit einem Abstand zu einer Torsionsachse des Mikrospiegel an Selbigem angeordnet sind, um durch Nutzung des Hebelgesetzes große Auslenkungen des Mikrospiegels zu ermöglichen.

Gemäß einem alternativen Ausführungsbeispiel umfassen vier, den schwingfähig aufgehängten Mikrospiegel mit Aktuatoren verbindende Torsionsfedern jeweils leidglich einen Krümmungsradius, sodass eine größere axiale Ausdehnung der Aktuatoren mit einer effizienten Bauraumnutzung durch die Federelemente kombiniert wird.

Weitere Ausführungsbeispiele zeigen die Anordnung von mehr als zwei Aktuatoren zum Versetzen des schwingfähig aufgehängten Mikrospiegels in eine Schwingung, um eine Verkippung des Mikrospiegel um eine zur Torsionsachse zusätzliche Achse zu ermöglichen.

Weitere vorteilhafte Ausführungsformen sind der Gegenstand der abhängigen Patentansprüche.

Bevorzugte Ausführungsbeispiele der vorliegenden Erfindung werden nachfolgend Bezug nehmend auf die beiliegenden Zeichnungen erläutert. Es zeigen:
- Fig. 1: eine schematische Darstellung des Aufbaus einer gekrümmten Torsionsfeder;
- Fig. 2: ein Histogramm der gekrümmten Torsionsfeder aus Fig. 1;
- Fig. 3: eine Aufsicht auf eine Vorrichtung mit einem Mikrospiegel, welcher über gekrümmte Torsionsfedern an Aktuatoren angeordnet ist;
- Fig. 4a: eine Seitenansicht der Vorrichtung aus Fig. 3 in einem unausgelenkten Zustand;
- Fig. 4b: eine Seitenansicht der Vorrichtung aus Fig. 3 in einem ausgelenkten Zustand;
- Fig. 5: eine Detailansicht eines Ausschnittes der Vorrichtung aus Fig. 3
- Fig. 6: eine Aufsicht auf eine Vorrichtung analog Fig. 3, bei der zusätzlich gerade Torsionsfedern angeordnet sind;
- Fig. 7: eine Aufsicht auf eine Vorrichtung analog Fig. 3, bei der die Torsionsfedern benachbart zum Mikrospiegel gemeinsame Bereiche umfassen;
- Fig. 8: eine Aufsicht auf eine Vorrichtung mit einem Mikrospiegel, welcher über einfach gekrümmte Torsionsfedern an Aktuatoren angeordnet ist;
- Fig. 9: ein Histogramm einer einfach gekrümmten Torsionsfeder aus Fig. 8;
- Fig. 10: eine Aufsicht auf eine Vorrichtung analog Fig. 8, bei der zwischen Aktuatoren und einem Ankerpunkt zusätzlich gekrümmte Torsionsfedern mit einem gemeinsamen Bereich analog Fig. 7 angeordnet sind;
- Fig. 11a-e: schematische Ansichten unterschiedlicher Anordnungen von Aktuatoren bezüglich der Torsionsachse und einer weiteren Symmetrieachse;

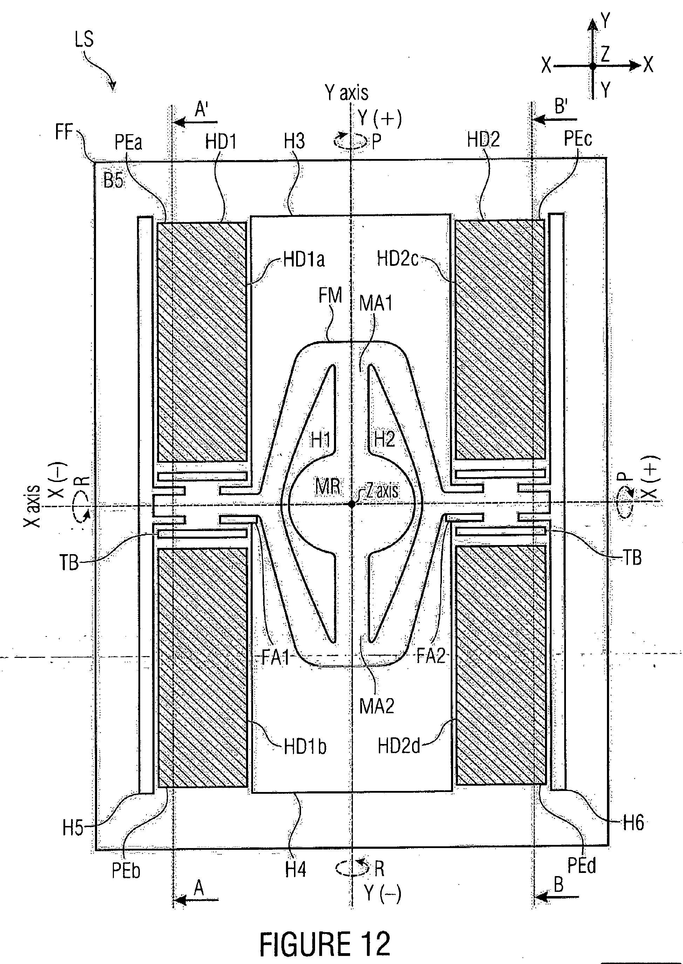

- Fig. 12: eine Schematische Aufsicht auf eine Vorrichtung mit Torsionsfedern gemäß dem Stand der Technik;
- Fig. 13a-b: Abbildungen einer Vorrichtung mit Torsionsfedern gemäß dem Stand der Technik, welche Defekte aufweisen;
- Fig. 14: eine Abbildung einer Vorrichtung mit gekrümmten Torsionsfedern, bei der die Aktuatoren an beiden Seiten auslenkbar angeordnet sind.

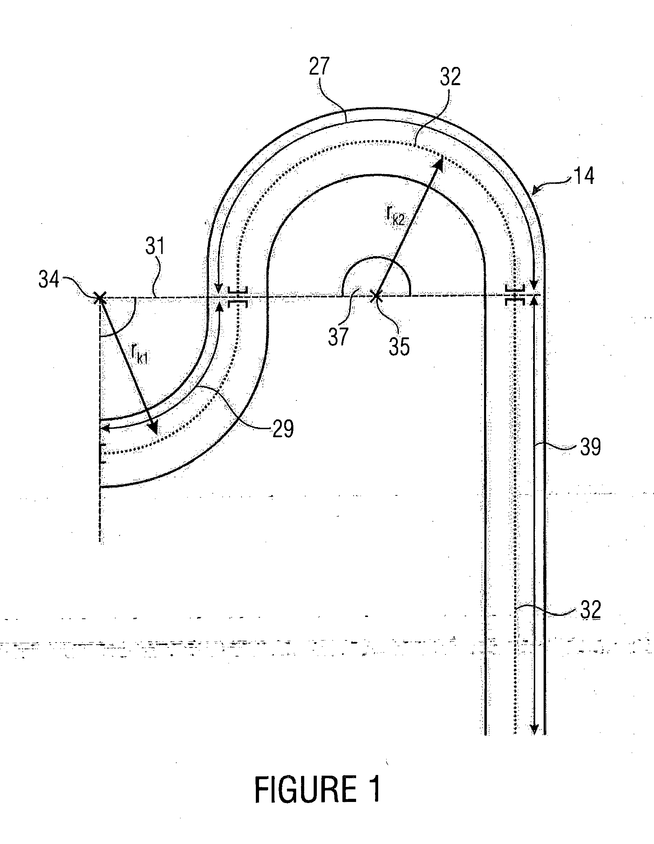

Fig. 1 zeigt eine gekrümmte Torsionsfeder 14, die eine Längsmittellinie 32 entlang der longitudinalen Ausdehnung der Feder umfasst. Von einem ersten Ende der Längsmittellinie 32 ausgehend umfasst selbige einen Krümmungsabschnitt 29, welcher eine Krümmung mit einem Krümmungsradius r_{K1} um einen Krümmungsmitteilpunkt 34 mit einem Öffnungswinkel 31 umfasst. Der Öffnungswinkel 31 umfasst beispielhaft in etwa 90°. In einem weiteren Verlauf der Längsmittellinie umfasst selbige einen Krümmungsabschnitt 27, welcher eine Krümmung mit einem Krümmungsradius r_{K2} um einen Krümmungsmittelpunkt 35 mit einem Öffnungswinkel 37 von hier exemplarisch 180° aufweist. Ausgehend vom Abschnitt 27 ist in Richtung des zweiten Endes der Längsmittellinie 32 ein Bereich 39 angeordnet, in welchem die Torsionsfeder 14 gerade ausgebildet ist und somit keine Krümmung umfasst, das heißt, eine Krümmung mit dem Wert Null bzw. einen Krümmungsradius unendlich aufweist.

In den Abschnitten 27 und 29 sind alle lokalen Orientierungen ausgehend von der initialen Orientierung einem Intervall mit einer Spannweite von 90° bzw. 180° gleichverteilt angeordnet, da alle Orientierungen aufgrund einer Kreisbogenförmigen Ausbildung der Krümmungsabschnitte gleichmäßig vorkommen, wohingegen die lokale Orientierung im Bereich 39 mangels Krümmung konstant ist.

Die Gleichverteilungen der Abschnitte 27 und 29 führen zu einer gleichmäßigen Höhe eines Sockelbereichs eines Histogramms der Torsionsfeder 14, wohingegen die Abschnitte, in denen die Torsionsfeder keine Krümmung und damit eine konstante lokale Orientierung umfasst zu einer zusätzlichen Amplitude des Histogramms für die Orientierungen dieser Abschnitte führen.

Die Krümmungsradien r_{K1}a-d und r_{K2}a-d können ein beliebiges Verhältnis zueinander aufweisen, wobei die Mittelpunkte 34 und 35 der Krümmungsradien in alternierender Weise auf je einer Seite entlang des Verlaufs der gekrümmten Torsionsfeder 14 angeordnet sind. Ein auf einer alternierenden Seite zu einem benachbarten Krümmungsmittelpunkt angeordneten Krümmungsmittelpunkt entspricht einem alternierenden Vorzeichenwechsel des Krümmungsradius entlang des Verlaufs der Längsmittellinie.

Obwohl in Fig. 1 zwei Krümmungsradien mit je einem Mittelpunkt an alternierenden Seiten entlang der Längsmittellinie angeordnet sind, kann auch lediglich ein Krümmungsradius oder eine beliebige, größere Anzahl an Krümmungsradien entlang der Längsmittellinie angeordnet sein, wobei Ausführungsbeispiele Torsionsfedern beschreiben, die weniger als zehn Vorzeichenwechsel der-Krümmungsradien aufweisen. Das bedeutet, dass das Federelement 14 als Torsionsfeder ausgebildet sein kann. Alternativ oder zusätzlich kann jedes gekrümmte Federelement 14 einer Vorrichtung so geformt sein, dass lokale Krümmungsradien r_{K1} r_{K2} entlang der Längsmittellinie 32 weniger als 10 Vorzeichenwechsel aufweisen.

Die Öffnungswinkel 31 und 37 beschreiben in Kombination mit den Krümmungsmittelpunkten 34 und 35 sowie den Krümmungsradien r_{K1} und r_{K2} Öffnungswinkel von Kreissektoren, entlang welchen die Krümmungen verlaufen, wobei die Öffnungswinkel jeweils kleiner als oder gleich 180° sind.

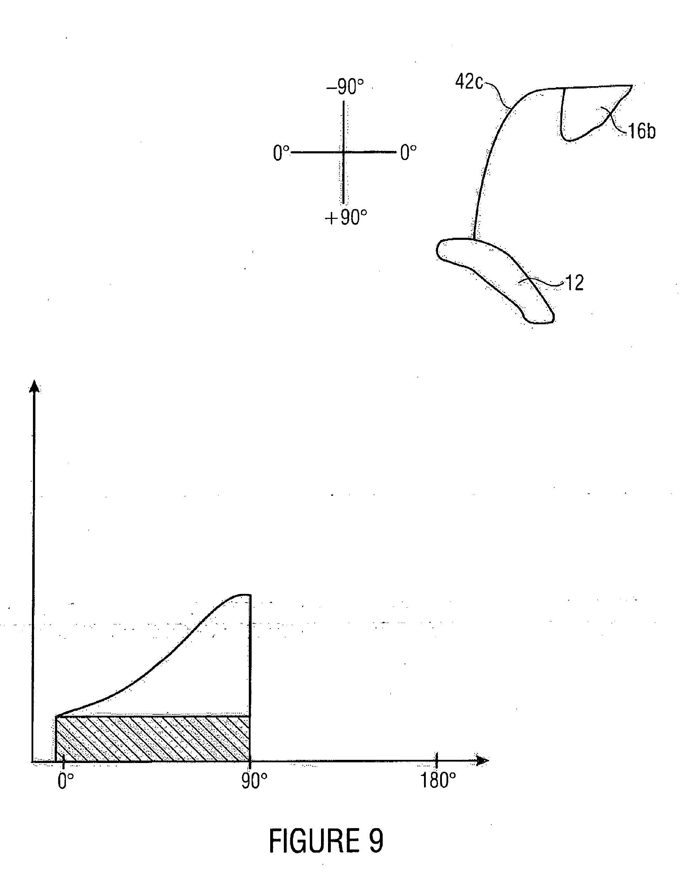

Obwohl sich in Fig. 1 der Krümmungsradius entlang der Länge der Torsionsfedern diskontinuierlich ändert, ist eine kontinuierliche Änderung natürlich ebenfalls möglich, was bezüglich Fig. 9 erläutert werden wird.

Alternativ oder zusätzlich können die Aktuatoren 16a und/oder 16b auch thermische Stellglieder umfassen.

Durch die bezüglich der Seite der Längsmittellinie 32 alternierende Positionierung der Krümmungsmittelpunkte weist die gekrümmte Torsionsfeder 14 im Falle eines einzelnen Krümmungsmittelpunkts den Verlauf eines Kreisbogens und im Falle mehrerer Krümmungsmittelpunkte einen S-förmigen Verlauf auf.

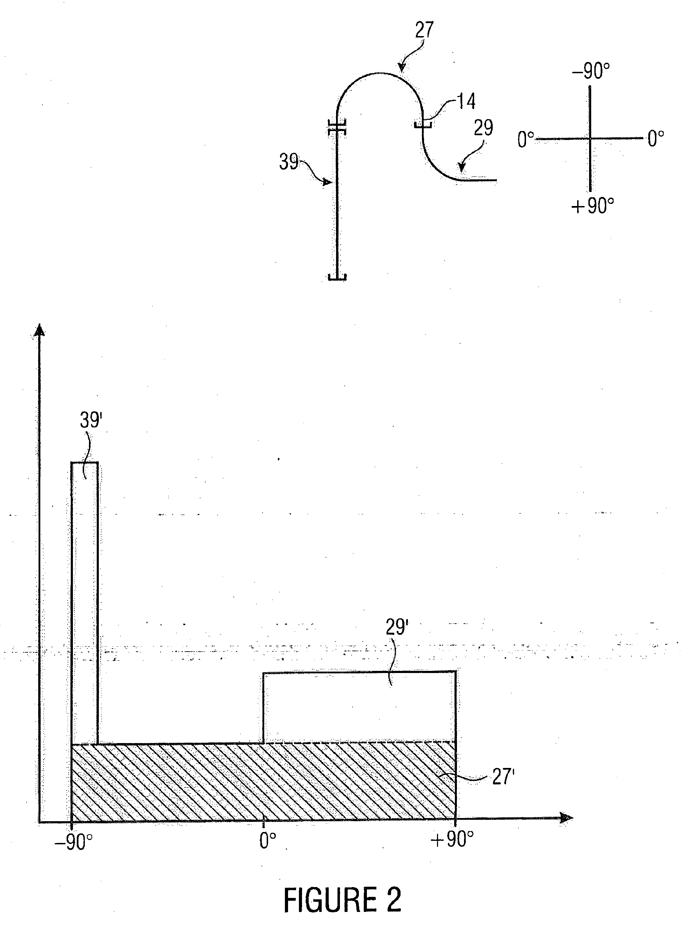

Fig. 2 zeigt ein Histogramm der lokalen Orientierung einer gekrümmten Torsionsfeder 14 aus Fig. 1 ausgehend vom Abschnittes 39 in der Orientierung -90° ausgebildet ist, was im Histogramm mit der Fläche 39' dargestellt ist. Im Abschnitt 39 ist die lokale Orientierung über die longitudinale Ausdehnung hinweg konstant, sodass die Länge des Abschnittes 39 anteilig mit der Orientierung -90° im Histogramm angeordnet ist. Die anschließende Rechtskrümmung der Torsionsfeder hin zur Orientierung +90° führt im Histogramm zu einem schraffiert dargestellten Sockelbereich 27', welcher der Gleichverteilung der lokalen Orientierungen entlang des Abschnitts 27 der Torsionsfeder 14 entspricht. Die im weiteren Federverlauf im Abschnitt 29 folgende Linkskrümmung entlang des Abschnittes 29 von der Orientierung +90° hin zu 0° führt zu der unschraffierten Fläche 29' zwischen 0° und +90° im Histogramm.

Die Spannweite des Histogramms beträgt gemäß des Minimums von -90° und des Maximums von +90° der lokalen Orientierungen der Torsionsfeder im Bereich ein Intervall von 180°. Dabei ist das Intervall zusammenhängend geformt, da jede-lokale Orientierung zwischen -90° und +90° im Verlauf der gekrümmten Torsionsfeder 14 ausgebildet ist, womit, wie der schraffierte Sockelbereich 27' des Histogramms darstellt, ein zumindest 10 prozentiger Anteil des Histogramms gleichverteilt zwischen der minimalen lokalen Orientierung - 90° und einer maximalen lokalen Orientierung von +90° verteilt ist.

Alternative Ausführungsbeispiele weisen gekrümmte Torsionsfedern mit lediglich einem oder mehreren Krümmungsradien auf, sodass deren Spannweite der Histogramme größer ist als 60° und kleiner als 360°. Das bedeutet, dass eine Spannweite des Histogramms im Bereich von ≥ 60° bis ≤ 360° liegen kann.

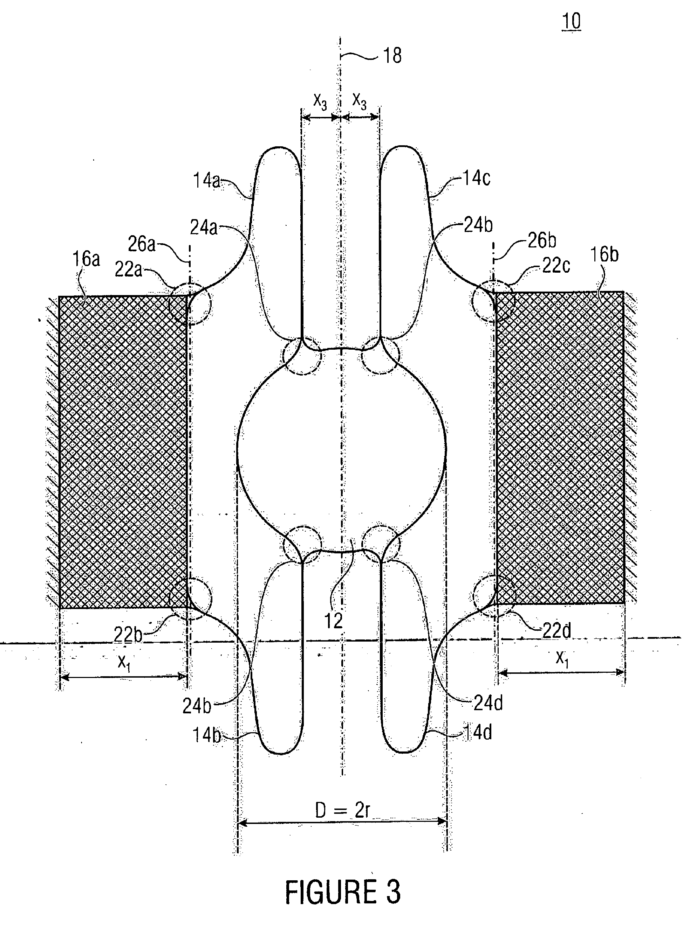

Fig. 3 zeigt eine Vorrichtung 10 mit einem schwingfähig aufgehängten (Mikro-)Spiegel 12, welcher mittig über vier gekrümmte Torsionsfedern 14a-d an zwei Aktuatoren 16a und 16b aufgehängt ist. Die Aktuatoren 16a und 16b sind jeweils einseitig fest eingespannt und derart angeordnet, dass ein auslenkbares Ende der Aktuatoren dem Mikrospiegel 12 zugewandt ist. Die Aktuatoren 16a und 16b sind als Piezoaktuatoren ausgebildet und umfassen je ein Substrat und eine daran angeordnete piezoelektrische Funktionsschicht, so dass die Aktuatoren 16a und 16b als Biegebalken ausgebildet sind. Ein Ansteuern eines Aktuators 16a oder 16b führt zu einer Auslenkung des der fest eingespannten Seite gegenüberliegend angeordneten auslenkbaren Endes in Richtung aus der Betrachtungsebene heraus, wie es nachfolgend graphisch dargestellt ist.

Werden die Aktuatoren 16a und 16b gegenphasig betrieben, so dass sich einer der Aktuatoren 16a oder 16b in eine dem Betrachter zugewandte Richtung und der jeweils andere Aktuator in eine dem Betrachter abgewandte Richtung bewegt, so verkippt der Mikrospiegel 12 um eine Torsionsachse 18. Werden die Aktuatoren hingegen gleichphasig betrieben so erfolgt eine Bewegung des Mikrospiegels 12 aus der Ebene der Torsionsachse 18 heraus. Die Aktuatoren 16a und 16b, der Mikrospiegel 12 sowie die gekrümmten Torsionsfedem 14a-d bilden ein Feder-Masse-System mit einer gemeinsamen Resonanzfrequenz. Die Aktuatoren 16a und 16b sind symmetrisch um die Torsionsachse 18 angeordnet, womit eine ebenfalls symmetrische Verkippung des Mikrospiegels 12 um die Torsionsachse 18 erzielt wird. An Aktuatoranbringungsorten 22a-d sind die gekrümmten Torsionsfedern 14a-d mit den Aktuatoren 16a und 16b verbunden. Die den Aktuatoren 16a und 16b abgewandten Enden der gekrümmten Torsionsfedern 14a-d sind an Spiegelanbringungsorten 24a-d mit dem Mikrospiegel 12 verbunden. Dabei sind sowohl die Aktuatoranbringungsorte 22a-d als auch die Spiegelanbringungsorte 24a-d derart ausgeführt, dass die Übergänge von den gekrümmten Torsionsfedern 14a-d zu den Aktuatoren 16a-b respektive von den gekrümmten Torsionsfedern 14a-d zum Mikrospiegel 12 abgerundet ausgeführt sind, wobei Außenkanten des jeweiligen gekrümmten Federelements 14a-d tangential an den Aktuator 16a oder 16b respektive den Mikrospiegel 12 geführt sind, und ein kantiger oder unstetiger Übergang zwischen den Elementen vermieden ist.

Der gekrümmte Verlauf der Torsionsfedern 14a-d erlaubt eine Ausgestaltung der Federn, die gegenüber gerade verlaufenden Federelementen mit einer größeren longitudinalen Ausdehnung versehen ist, sodass durch Verformung im Material der Federn induzierte Kräfte in einem größeren Materialbereich verteilt werden. Ein stetiger Übergang der unterschiedlichen Krümmungsradien führt im Gegensatz zu eckig und damit unstetig umgelenkten Torsionsfedern zu einer Vermeidung von Kraftspitzen an den Unstetigkeitsstellen.

Ein abgerundeter Übergang zwischen den Elementen Aktuator/Feder respektive Feder/Mikrospiegel verringert das Auftreten von Kraftspitzen im Material bei einer Verformung und vermeidet überhöhte Materialermüdungen an diesen Stellen. Damit wird eine zusätzlich erhöhte Betriebsdauer der Vorrichtung erreicht.

Zur Verringerung von Dreh- oder Kippbewegungen um eine andere als die Torsionsachse 18 sind die Aktuatoranbringungsorte 22a-d derart zueinander angeordnet, dass die Aktuatoranbringungsorte 22a und 22b sowie die Aktuatoranbringungsorte 22c und 22d je paarweise auf einer Linie 26a und 26b angeordnet sind, wobei die Linien 26a und 26b parallel zur Torsionsachse 18 verlaufen. In Kombination mit einer symmetrischen Anordnung der Spiegelanbringungsorte 24a-d wird eine Minimierung von nicht um die Torsionsachse 18 führenden Bewegungen des Mikrospiegels 12 erreicht.

Die Aktuatoren 16a und 16b können derart ausgebildet sein, dass eine longitudinale Ausdehnung x₁ der Aktuatoren 16a und 16b größer ist als ein Radius des runden Mikrospiegels 12. Eine vergrößerte Ausbildung der Ausdehnung x₁ ermöglicht eine größere Auslenkung des auslenkbaren Endes der Aktuatoren und mithin der Aktuatoranbringungsorte 22a-d. Diese größere Auslenkung erzeugt eine größere Materialdeformation, welche durch die Ausgestaltungsform der gekrümmten Torsionsfedern 14a-d ermöglicht wird. Dabei bezeichnet die longitudinale Abmessung x₁ einen Abstand von der festen Einspannung eines Aktuators 16a oder 16b entlang einer senkrecht zur Torsionsachse 18 angeordneten Achse hin zu einem Aktuatoranbringungsort 22a-b, also eine Abmessung entlang einer Ausdehnung, in der sich die Aktuatoren gemäß der Ausgestaltung als Biegebalken krümmen.

Die Spiegelanbringungsorte 24a-d sind mit einem Abstand x₃ von der Torsionsachse 18 angeordnet. Der Abstand x₃ erzeugt eine Hebelwirkung derart, dass eine durch die Aktuatoren 16a und 16b induzierte und über die gekrümmten Torsionsfedern 14a-d übertragene Auslenkung der Aktuatoren 16a und 16b in einem Maße an den Mikrospiegel 12 abgegeben wird, das von dem Abstand x₃ abhängt.

Der Mikrospiegel 12 ist in Fig. 1 rund und mit einem konstanten Radius r ausgebildet. In Ausführungsbeispielen umfasst ein alternativer Mikrospiegel eine andere Form, beispielsweise eine Ellipse. In diesem Fall kann der Abstand x₁ derart gewählt werden, dass er größer ist als die Hälfte des die längste Entfernung zweier beliebiger Punkte einer Hauptseite des Mikrospiegels 12. Ist der Mikrospiegel 12, wie in Fig. 1 gezeigt, als rundes Element ausgeführt, entspricht die Hälfte der längsten Abmessung zweier beliebiger Punkte dem Radius r.

Der die Hebelwirkung definierende Abstand x₃ erlaubt gegenüber einer Anordnung von Torsionsfedern in der Torsionsachse bei gleicher Kraft der Aktuatoren 16a und 16b eine größere Auslenkung des Mikrospiegels 12 respektive eine identische Auslenkung des Mikrospiegels 12 bei geringerer Aktuatorauslenkung.

Weitere Ausführungsbeispiele zeigen die Anordnung mehrerer Aktuatoren, wobei die Aktuatoren symmetrisch um die Torsionsachse und/oder eine Symmetrieachse senkrecht zur Torsionsachse angeordnet sind und an jedem Aktuator lediglich eine gekrümmte Torsionsfeder angeordnet ist. Der Abstand x₂ ist dann als der Abstand zweier Aktuatoranbringungsorte in einer durch die Torsionsachse oder die Symmetrieachse definierten Halbebene bestimmt.

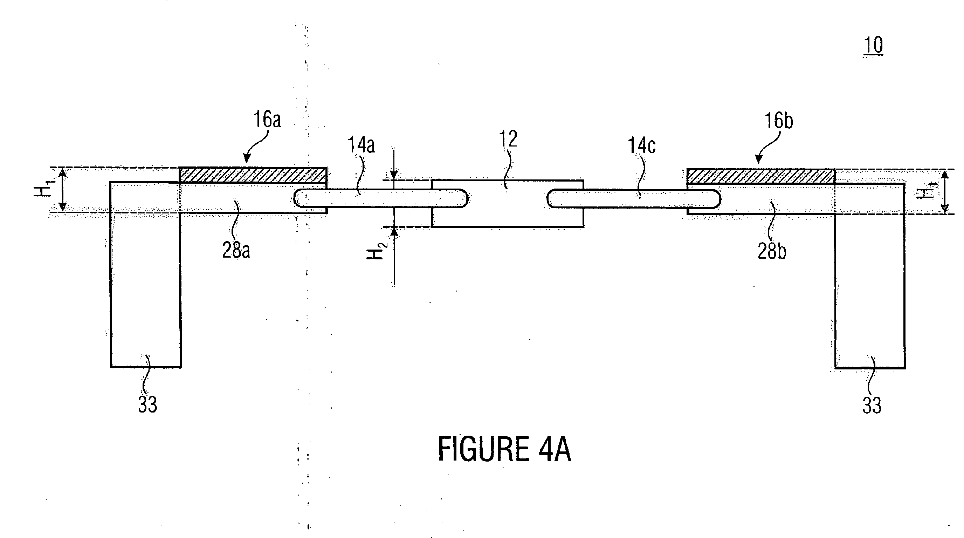

Fig. 4a zeigt eine Seitenansicht der Vorrichtung 10 in einem unausgelenkten Zustand. Die Aktuatoren 16a und 16b sind analog Fig. 3 jeweils als ein Substrat 28a und 28b und eine piezoelektrische Funktionsschicht umfassende Piezoaktuatoren ausgebildet. Die Aktuatoren 16a und 16b umfassen eine Dicke H₁, die in einem definierten Verhältnis zu einer Dicke H₂ des Mikrospiegels 12 steht, wobei das Verhältnis von H₁ und H₂ in etwa 1:1 entspricht. Alternative Ausführungsbeispiele umfassen ein Verhältnis H₁ und H₂ zwischen 0,1 und 2.

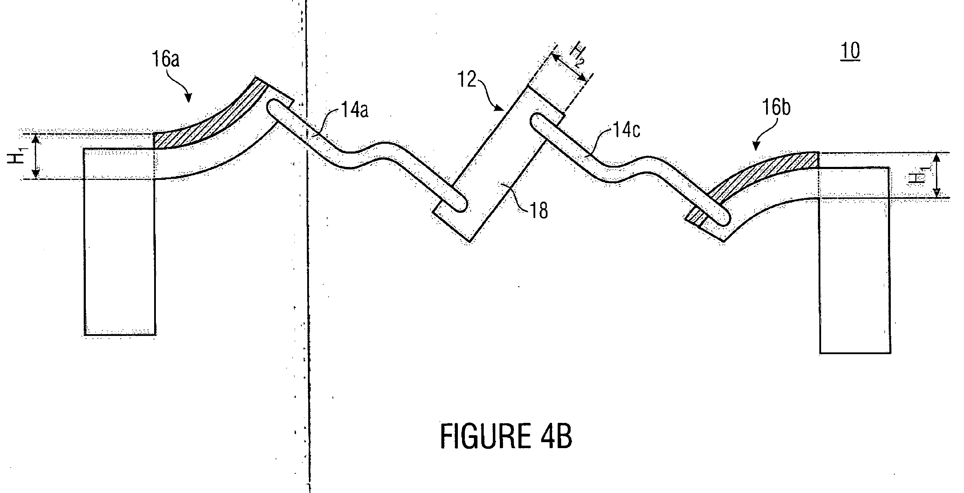

Das Substrat 28a und 28b der Aktuatoren 16a und 16b, die gekrümmten Torsionsfedern 14a und 14b sowie der Mikröspiegel 12 können, wie exemplarisch in Fig. 4a und 4b dargestellt, aus demselben Material und einstückig gebildet sein, wobei die einstückige Ausbildung beispielsweise mittels eines zeitgesteuerten Ätzprozesses oder einer Ätzstoppschicht aus einem gemeinsamen Ausgangsträger erfolgen kann. Ferner ist das Substrat 33, an welcher die Aktuatoren 16a und 16b aufgehängt sind, ebenfalls einstückig mit dem Substrat 28a und 28b der Aktuatoren 16a und 16b und mithin den gekrümmten Torsionsfedern 14a und 14b sowie dem Mikrospiegel 12 gebildet, so dass beispielsweise der zeitlich gesteuerte Ätzprozess Volumenanteile eines Abschnittes eines Wafers an lateral und axial unterschiedlichen Stellen entfernt, wobei die Strukturen des Substrats 28a und 28b der Aktuatoren 16a und 16b, die der gekrümmten Torsionsfedern 14a und 14b sowie des Mikrospiegels 12 wie das Substrat 33 aus dem Abschnitt des Wafers herausgebildet werden. Das bedeutet, dass die gekrümmte Federelemente 14a und 14b und das schwingfähig aufgehängte optische Element (Mikrospiegel) 12 einstückig aus dem Substrat 33 gebildet sein können, aus dem auch eine Lagerung gebildet ist, an der die Aktuatoren 16a und 16b fest gelagert sind.

Fig. 4b zeigt Vorrichtung 10 in einem ausgelenkten Zustand, bei dem der Aktuator 16a in eine Richtung und der Aktuator 16b in eine entgegengesetzte Richtung ausgelenkt ist. Die Auslenkung der Aktuatoren 16a und 16b führt zu einer Verformung der gekrümmten Torsionsfedern 14a und 14b und zu einer Verkippung des Mikrospiegels 12 um die Torsionsachse 18.

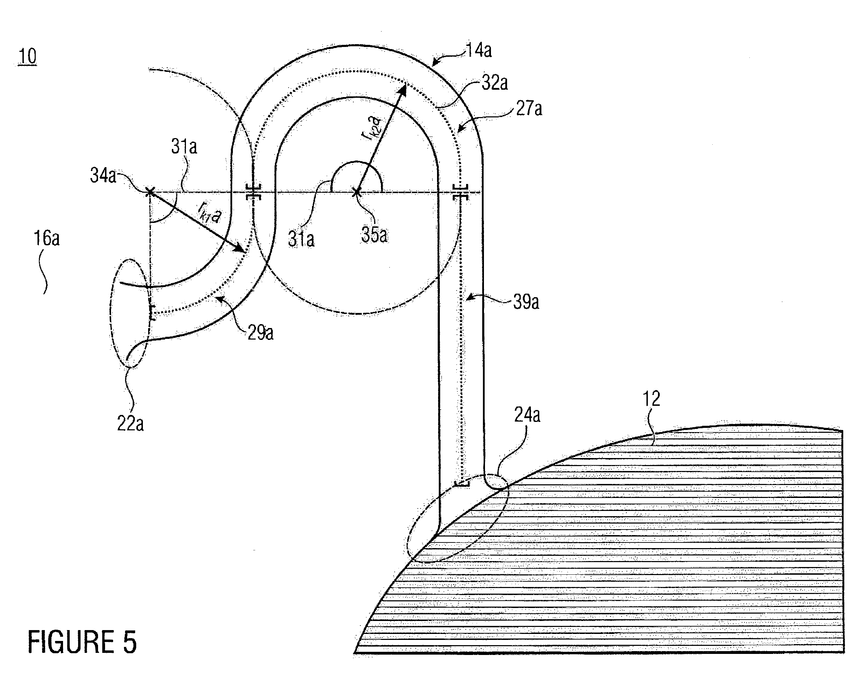

Fig. 5 zeigt einen Ausschnitt der Fig. 1 mit einer Aufsicht auf die Anbringungsorte 22a und 24a, welche die Torsionsfeder 14a tangential mit dem Mikrospiegel 12 und dem Aktuator 16a verbinden, sowie den Verlauf der gekrümmten Torsionsfeder 14a. Eine Längsmittellinie 32a der gekrümmten Torsionsfeder 14a weist entlang ihres stetigen Verlaufs den gerade ausgeformten Abschnitt 39a sowie die beiden Krümmungsabschnitte 27a und 29a auf, die je einen konstanten Krümmungsradius r_{K1}a bzw. r_{K2}a und einen Krümmungsmittelpunkt 34a bzw. 35a umfassen. Die lokalen Krümmungsradien r_{K1}a und r_{K2}a können derart ausgebildet sein, dass sie jeweils größer sind als die Hälfte der mittleren Breite der gekrümmten Torsionsfeder und gleichzeitig in jedem Krümmungsabschnitt 27a und 29a der Mittelwert des Betrages des jeweiligen Krümmungsradius r_{K1}a oder r_{K2}a kleiner ist als das 10-fache der gesamten Länge der Längsmittellinie 32a. Alternativ kann jedes gekrümmte Federelement 14a und 14b so geformt sein, dass ein lokaler Krümmungsradius r_{K1} bzw. r_{K2} der Längsmittellinie 32 betragsmäßig über eine Länge der Längsmittellinie 32 hinweg mehr als die Hälfte einer mittleren Breite des jeweils gekrümmten Federelementes 14a bzw. 14b ist. Alternativ oder zusätzlich kann jedes gekrümmte Federelement 14a und 14b so geformt sein, dass ein Mittelwert des Betrags des Krümmungsradius r_{K1} bzw. r_{K2} über Abschnitte 27 und/oder 29 der Längsmittellinie 32, in welchem das jeweilige Federelement 14a und 14b gekrümmt ist, kleiner als das 10-fache der Länge der Längsmittellinie 32 ist.

Ein schwingfähig aufgehängtes optisches Element, beispielweise ein Mikrospiegel, kann gemäß alternativen Ausführungsbeispielen auch ohne einen Aktuator über gekrümmte Federelemente an einem Substrat angeordnet sein, insbesondere wenn eine Energie zum Versetzen des schwingfähig aufgehängten optischen Elementes in eine Schwingung auf alternative Weise in das schwingfähige System eingebracht wird, bspw. über eine Fluidströmung, welche das schwingfähig aufgehängte optische Element umströmt.

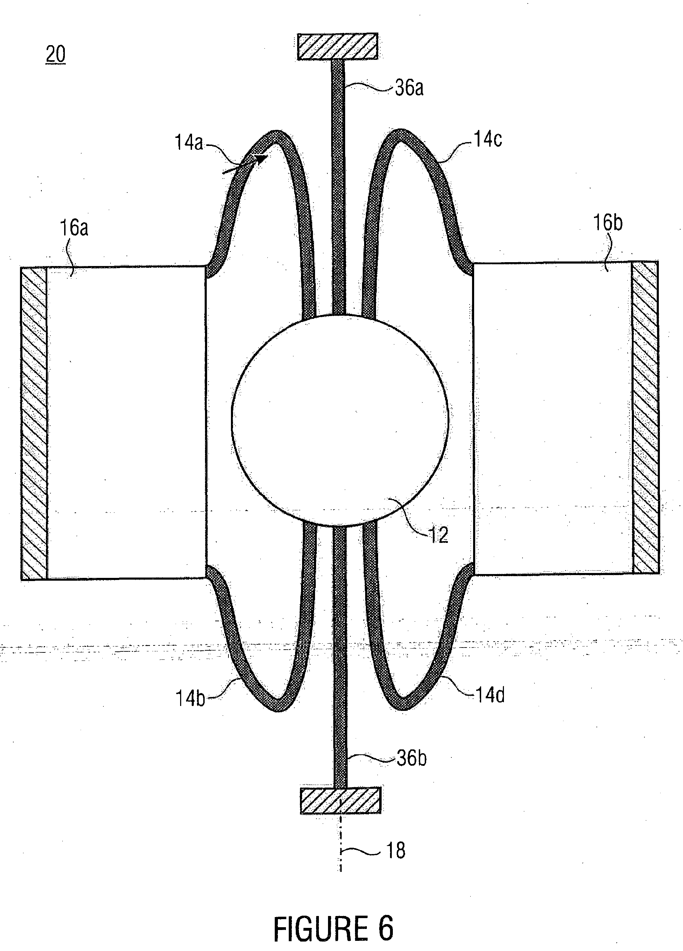

Fig. 6 zeigt eine Aufsicht auf eine Vorrichtung 20, bei der Vorrichtung 10 dahin gehend erweitert ist, dass am Mikrospiegel 12 zusätzlich zwei gerade geführte Torsionsfedern 36a und 36b angeordnet sind, deren dem Mikrospiegel 12 abgewandtes Ende an einem unbeweglichen Ankerpunkt angeordnet ist und deren longitudinaler Verlauf deckungsgleich mit der Torsionsachse 18 verläuft. Dabei weisen die geraden Torsionsfedern 36a und 36b keine direkte Verbindung zu den gekrümmten Torsionsfedern 14a-d auf. Die geraden Torsionsfedern 36a und 36b sind ausgebildet, um die Verkippung des Mikrospiegels 12 zu stabilisieren.

Obwohl in Fig. 6 die Anordnung von zwei gerade geführte Torsionsfedern 36a und 36b beschrieben ist, umfassen alternative Ausführungsbeispiele eine andere Anzahl von geraden Torsionsfedern, welche symmetrisch um und parallel zur Torsionsachse 18 angeordnet sind.

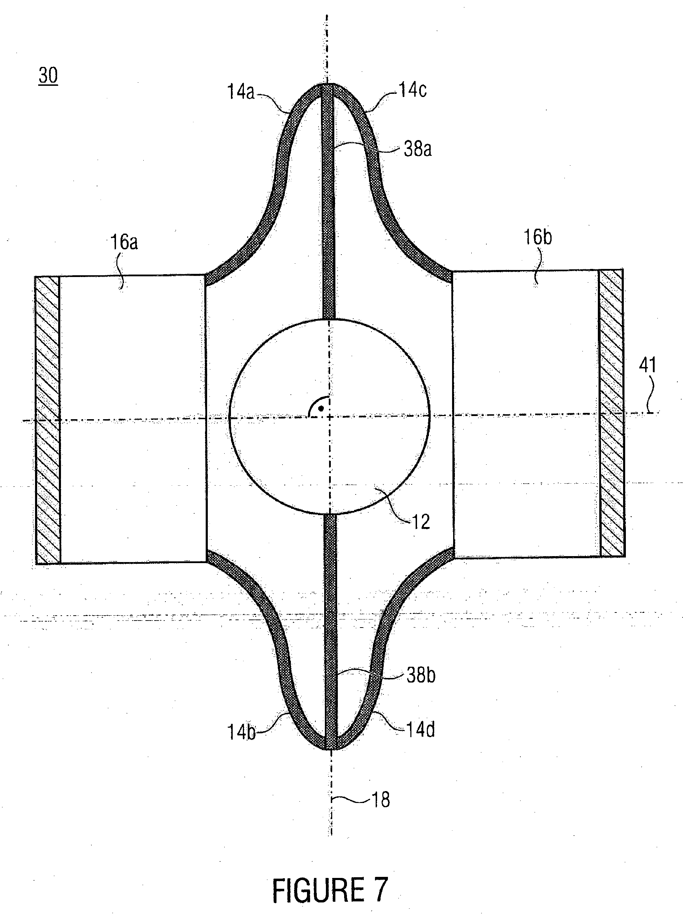

Fig. 7 zeigt eine Aufsicht auf eine Vorrichtung 30, bei der der Mikrospiegel 12 über vier gekrümmte Torsionsfedern 14a-d an den Aktuatoren 16a und 16b angeordnet ist. Dabei sind die gekrümmten Torsionsfedern 14a-d derart geformt, dass jeweils zwei, auf einer Seite einer Symmetrieachse 41, welche senkrecht zur Torsionsachse 18 angeordnet ist, angeordnete gekrümmte Torsionsfedern 14a und 14c sowie 14b und 14d einen gemeinsamen Abschnitt 38a und 38b der Torsionsfedern umfassen. Von den jeweiligen Aktuatoranbringungsorten verlaufen die gekrümmten Torsionsfedern 14a-d in einem gekrümmten Verlauf hin zur Torsionsachse 18, wobei an der Torsionsachse 18 die gekrümmte Torsionsfeder 14a mit der gekrümmten Torsionsfeder 14c und die gekrümmte Torsionsfeder 14b mit der gekrümmten Torsionsfeder 14d zusammengeführt ist und den gerade ausgebildeten weiteren Verlauf 38a der gekrümmten Torsionsfedern 14a und 14c respektive den weiteren, geraden ausgebildeten Verlauf 38b der gekrümmten Torsionsfedern 14b und 14d bilden. Der Abstand x₃ aus Vorrichtung 10 in Fig. 1 ist mit einer Ausdehnung von Null ausgebildet.

Mit einer in obigem Ausführungsbeispiel gezeigten Zusammenführung der gekrümmten Federelemente können Fertigungstoleranzen bei der Herstellung der Vorrichtung derart ausgeglichen werden, dass anstelle von vier Spiegelanbringungsorten lediglich zwei Spiegelanbringungsorte ausgeführt werden, für die folglich lediglich eine Ausrichtung bezüglich der Törsionsachse des Mikrospiegels erforderlich ist, womit eine höhere Präzision der Kippbewegung des Mikrospiegels 12 erreicht wird.

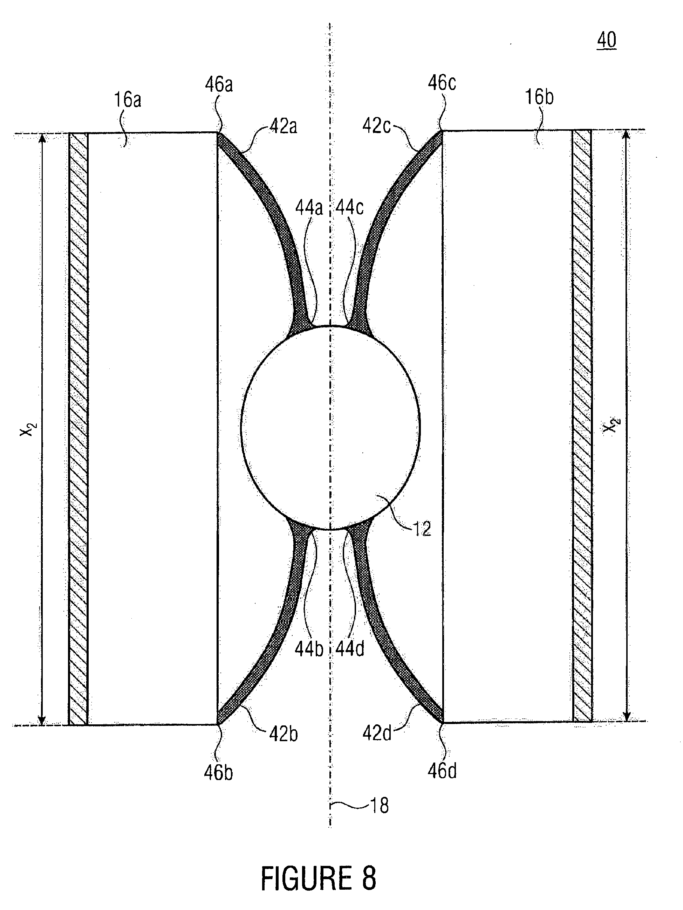

Fig. 8 zeigt ein Vergleichsbeispiel einer Torsionsfeder. Eine Vorrichtung 40, welche einfach gekrümmte Torsionsfedern 42a-d umfasst, welche den Mikrospiegel 12 derart mit den Aktuatoren 16a und 16b verbinden, dass eine durch die Aktuatoren 16a und 16b induzierte Anregung den Mikrospiegel 12 um die Torsionsachse 18 verkippt oder entlang einer Ebene, die die Torsionsachse 18 umfasst, bewegt. Die einfach gekrümmten Torsionsfedem 42a-d sind an Spiegelanbringungsorten 44a-d mit dem Mikrospiegel 12 verbunden. Dabei sind die Spiegelanbringungsorte 44a-d analog den Spiegelanbringungsorten vorangegangener Ausführungsbeispiele abgerundet ausgebildet, so dass auftretende Spitzen bezüglich Materialbelastungen an strukturellen Übergängen zwischen den einfach gekrümmten Torsionsfedern 42a-d und dem Mikrospiegel 12 minimiert sind.

Ein lateraler Abstand x₂ zwischen den Aktuatoranbringungsorten 46a und 46b sowie zwischen 46c und 46d beträgt bspw. mehr als 150 % der größten Entfernung zweier beliebiger Punkte einer Hauptseite des Mikrospiegels 12. Eine größere Abmessung x₂ führt zu einer größeren auslenkenden Kraft und mithin ein schnelleres Auslenken des Mikrospiegels 12. Das bedeutet, dass der Abstand x₂ zwischen den Befestigungsorten 46a-d eines Aktuators 16a bzw. 16b mehr als 150 % der größten Entfernung zweier beliebiger Punkte einer Hauptseite des optischen Elementes 12 betragen kann.

Analog den Aktuatoranbringungsorten 22 der gekrümmten Torsionsfedern 14 sind auch Aktuatoranbringungsorte 46a-d der einfach gekrümmten Torsionsfedern 42a-d abgerundet respektive tangential an die Aktuatoren 16a und 16b geführt. Sämtliche Krümmungsradien der einfach gekrümmten Torsionsfedern 42a-d liegen entlang einer stetigen Längsmittellinie der einfach gekrümmten Torsionsfedern 42a-d auf derselben Seite der Längsmittellinie, wobei ein Mittelwert eines jeden Krümmungsradius kleiner ist als das 10-fache der Länge der Längsmittellinie. Dadurch sind die einfach gekrümmten Torsionsfedern 42a-d derart ausgebildet, dass ihr Verlauf in etwa einer Viertel-Ellipse entspricht. Das bedeutet, dass jedes gekrümmte Federelement 42a-d so geformt sein kann, dass ein Mittelwert des Krümmungsradius r_{K1} bzw. r_{K2} über Abschnitte 27a, 29a und/oder 39a der Längsmittellinie 32, in welchem das jeweilige Federelement 42a-d gekrümmt ist, kleiner als das 10-fache der Länge der Längsmittellinie 42a-d ist.

Alternative Vergleichsbeispiele zeigen einfach gekrümmte Torsionsfedern, deren Verlauf in etwa einem Kreisbogen entspricht. Dabei umfassen die Verläufe der einfach gekrümmen Torsionsfedern entlang ihres-Verlaufs einen oder mehrere Krümmungsradien um einen oder mehreren Krümmungsmittelpunkten, wobei sämtliche Krümmungsmittelpunkte an derselben Seite der Längsmittellinie der jeweiligen einfach gekrümmten Torsionsfeder angeordnet sind und jeder lokale Krümmungsradius über eine Länge der Mittellinie hinweg betragsmäßig größer ist als die Hälfte einer mittleren Breite der jeweiligen einfach gekrümmten Torsionsfeder.

Zur Reduzierung des benötigen Bauraums der Gesamtstruktur kann die Anordnung von einfach gekrümmten Torsionsfedern gegenüber der Anordnung von gekrümmten Torsionsfedern der vorangegangenen Ausführungsbeispiele vorteilhaft sein. In Fig. 8 ist die Krümmung der einfach gekrümmten Torsionsfedern 42a-d derart ausgebildet, dass die einfach gekrümmten Torsionsfedern 42a-d von den Aktuatoranbringungsorten 46a-d ausgehend lediglich Abschnitte umfassen, die, mit Ausnahme der Aktuatoranbringungsorte 46a-d, lediglich in Richtung des Mikrospiegels 12 hinweisen respektive eine Krümmung in Richtung des Mikrospiegels 12 beschreiben. In vorangegangenen Ausführungsbeispielen waren die gekrümmten Torsionsfedern 14 derart ausgeführt, dass von Aktuatoranbringungsorten 22a-d ausgehend Abschnitte der gekrümmten Torsionsfedern 14a-d vom Mikrospiegel 12 wegweisen und eine maximale laterale Ausdehnung in Richtung der Torsionsachse 18 durch die laterale Ausdehnung der gekrümmten Torsionsfedern 14a-d definiert wird. Dahingegen wird der maximale laterale Bauraum in Richtung der Torsionsachse 18 der Vorrichtung 40 durch die laterale Ausdehnung der Aktuatoren 16a und 16b definiert.

Fig. 9 zeigt ein Histogramm der Krümmungsverläufe der einfach gekrümmten Torsionsfeder 42c der Vorrichtung 40 aus Fig. 8 ausgehend vom Aktuator 16b in Richtung des Mikrospiegels 12. Ausgehend von der tangentialen Anordnung der einfach gekrümmten Torsionsfeder 42c am Aktuator 16b mit der lokalen Orientierung 0° verläuft die Krümmung der einfach gekrümmten Torsionsfeder 42c stetig hin zu einer Orientierung von +90°. Von einer minimalen Orientierung 0° hin zu einer maximalen Orientierung +90° umfasst das Histogramm eine Spannweite von 90°. Zumindest 10 % der Integralfläche des Histogramms, die in Fig. 9 schraffiert dargestellt sind, sind dabei gleichverteilt angeordnet, das bedeutet: eine Gleichverteilung über die Spannweite mit einer Fläche von 10 % des Histogramms bleibt über die gesamte Spannweite hinweg unterhalb des Histogramms. Gleichzeitig enthält das Histogramm der Fig. 9 kein zusammenhängendes oder nicht zusammenhängendes Intervall mit einer Länge von 6°, welches die Fläche des Histogramms zu mehr als 90 % umfasst, so dass die Orientierungen einer einfach gekrümmten Torsionsfeder ein Maß an Gleichverteilung innerhalb der Spannweite umfassen. Der kontinuierliche Verlauf des nichtschraffierten Bereichs zeigt, dass sich Krümmungsradien kontinuierlich entlang des Verlaufs der Torsionsfeder ändern. Das bedeutet, dass jedes gekrümmte Federelement 42a-d so geformt sein kann, dass die lokale Orientierung entlang der Längsmittellinie 32 einen stetigen Verlauf aufweist.

Alternative Vergleichsbeispiele umfassen einfach gekrümmte Torsionsfedern, deren Histogramme Spannweiten von größergleich 60° und kleinergleich 270° umfassen. Das bedeutet, dass die Spannweite des Histogramms im Bereich von ≥ 60° bis ≤ 270° liegen kann.

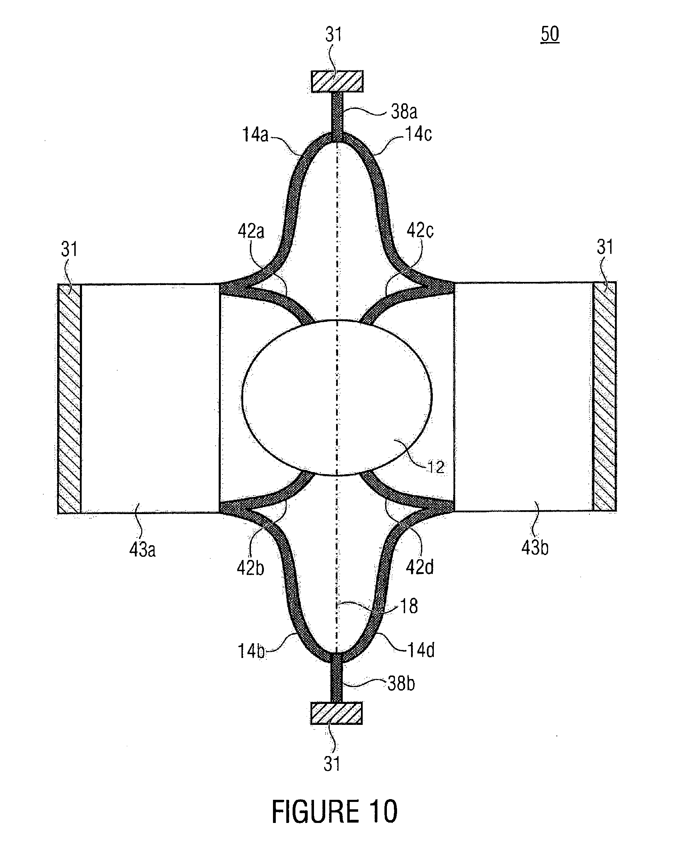

Fig. 10 zeigt eine schematische Aufsicht auf eine Vorrichtung 60, die einen Mikrospiegel 12 umfasst, welcher über vier einfach gekrümmte Torsionsfedern 42a-d an den Aktuatoren 16a und 16b angeordnet ist. Zusätzlich sind an den Aktuatoren 16a und 16b gekrümmte Torsionsfedern 14a-d angeordnet, die eine Auslenkung der Aktuatoren 16a und 16b gegenüber dem Substrat 33 abstützen. Die gekrümmten Torsionsfedern 14a und 14c sowie 14b und 14d weisen je paarweise und analog Fig. 5 die gemeinsamen Abschnitte 38a und 38b der gekrümmten Torsionsfedern auf.

Durch die zusätzliche Anordnung von gekrümmten Torsionsfedern zwischen Aktuatoren und Substrat kann eine Stabilisierung der Auslenkbewegung erreicht werden, wobei prinzipiell eine beliebige Kombination von gekrümmten und einfach gekrümmten Torsionsfedern möglich ist.

Prinzipiell können die den Aktuatoren 16a und 16b abgewandten Enden der gekrümmten Torsionsfedern 14a-d auch an weiteren Aktuatoren angeordnet sein, damit der Mikrospiegel 12 entlang einer zweiten, von der Torsionsachse 18 verschiedenen, Achse drehbar oder entlang einer Achse senkrecht zur Torsionsachse 18 beweglich angeordnet ist.

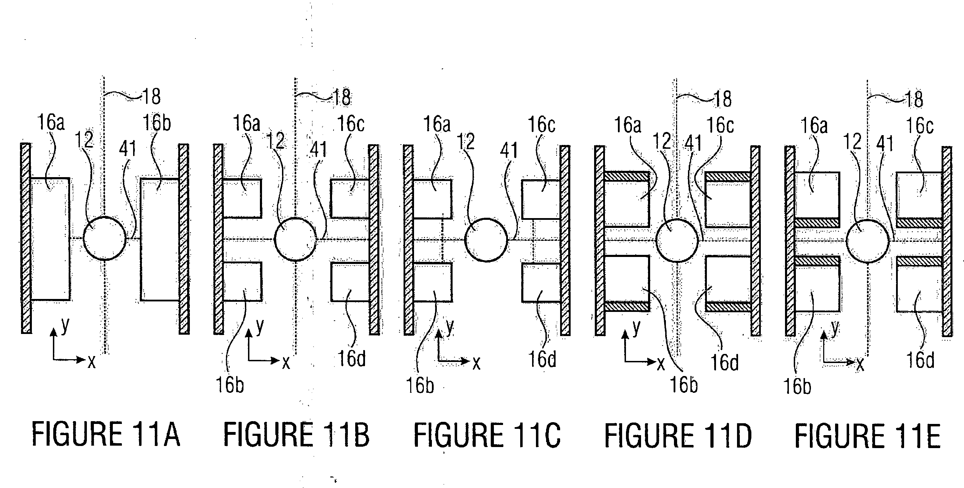

Fig. 11 zeigt schematisch Anordnungsmöglichkeiten von Aktuatoren 16a-d bezüglich des Mikrospiegels.

Fig. 11a zeigt analog den vorangegangenen Ausführungsbeispielen eine Anordnung der Aktuatoren 16a und 16b symmetrisch um die Torsionsachse 18. Die Aktuatoren 16a und 16b sind dabei parallel und beabstandet zur Torsionsachse 18 an einer dem Mikrospiegel 12 abgewandten Seite fest eingespannt und symmetrisch zur Symmetrieachse 41 angeordnet.

Fig. 11b zeigt eine Anordnung von vier Aktuatoren 16a-d, die sowohl symmetrisch zur Torsionsachse 18 als auch symmetrisch zur Symmetrieachse 41 angeordnet sind, so dass jeweils ein Aktuator 16a-d in einem Quadranten eines von der Torsionsachse 18 und der Symmetrieachse 41 aufgespannten Koordinatensystems angeordnet ist.

Fig. 11c zeigt eine Anordnung von Aktuatoren analog Fig. 11b, bei der durch Punkte zwischen den Aktuatoren 16a und 16b sowie zwischen den Aktuatoren 16c und 16d eine Anordnung weiterer Aktuatoren angedeutet ist. Weitere Aktuatoren sind symmetrisch zur Symmetrieachse 41 angeordnet. Werden beispielswiese ein zusätzlicher fünfter und sechster Aktuator angeordnet, so wird Fig. 11b dahin gehend erweitert, dass der zusätzliche fünfte und sechste Aktuator im Verlauf der Symmetrieachse 41 angeordnet sind.

Fig. 11d zeigt eine Anordnung von Aktuatoren 16a-d analog Fig. 11b, bei der die Aktuatoren in einem Verlauf parallel zur Symmetrieachse 41 fest eingespannt sind und die frei auslenkbaren Enden der Aktuatoren 16a-d der Symmetrieachse 41 zugewandt sind und parallel zur Symmetrieachse 41 verlaufen.

Fig. 11e zeigt eine Anordnung von Aktuatoren 16a-d analog Fig. 11d, bei der die feste Einspannung der Aktuatoren 16a-d der Symmetrieachse 41 zugewandt und das frei auslenkbare Ende der Aktuatoren 16a-d der Symmetrieachse 41 abgewandt angeordnet ist.

Prinzipiell kann eine beliebige Anzahl von Aktuatoren angeordnet sein, wobei die Aktuatoren sowohl symmetrisch zur Torsionsachse 18 als auch symmetrisch zur Symmetrieachse 41 senkrecht zur Torsionsachse 18 angeordnet sind und sich die Symmetrieachsen im Mittelpunkt des Mikrospiegels 12 schneiden.

Durch die beschriebenen Ausführungsbeispiele wird ein oszillierendes System geschaffen, welches einen Mikrospiegel und außenstehende piezoelektrische Aktuatoren umfasst. Im Gegensatz zu bekannten Lösungen können die Aktuatoren so ausgebildet sein, dass sie höhere Resonanzfrequenzen umfassen, als der Mikrospiegel, so dass eine Verwendung einer größeren Schichtdicke der Aktuatoren ermöglicht wird und durch die größere Schichtdicke die Gesamtstruktur robuster ausgestaltet ist.

Weiterhin können die Aktuatoren in der zero-node-mode, der ersten Eigenmode eines Biegebalkens, betrieben werden. Im Gegensatz zur one-node-mode sind bei der zero-node-mode benachbarte parasitäre Moden im Frequenzbereich relativ weit beabstandet, so dass die Eigenmode dominant ist und ein, den Betrieb des Mikrospiegels einschränkender, Einfluss von parasitären Moden reduziert ist.

Ferner sind unstetige Materialverläufe von Torsionsfedern, wie beispielsweise bei den in Fig. 13 gezeigten Torsionsfedern, die mit einem 90°-Winkel ausgebildet sind, vermieden, indem die gekrümmten und einfach gekrümmten Torsionsfedern einen stetigen Verlauf aufweisen und somit Kraftspitzen und-mechanisch überbelastete Stellen entlang des Verlaufs der gekrümmten und einfach gekrümmten Torsionsfedern verhindert sind. Abgerundet respektive tangential ausgestaltete Anbringungsorte der Federn an dem Mikrospiegel und/oder den Aktuatoren verhindern zudem mechanisch überbelastete Stellen an den Enden der Torsionsfedern.

Insgesamt weist das beschriebene Mikrospiegelsystem eine hohe Resonanzfrequenz auf, welches stabil und robust ausgestaltet ist. Sind die Torsionsfedern mit einem Abstand von der Torsionsachse an dem Mikrospiegel angeordnet, so ist das Hebelgesetz dahingehend nutzbar, dass der Abstand von der Torsionsachse zu den Spiegelanbringungsorten als Hebelarm wirkt und die Kraft der Aktuatoren effizient übertragen wird, womit eine große Auslenkung des Mikrospiegels erzielt werden kann. Die Nutzung der Torsionsfedern als Hebel verhindert durch die Ausgestaltung der Torsionsfedern und der Anbringungsorte an Aktuatoren und Mikrospiegel gleichzeitig Stellen mit zu hoher mechanischer Spannung.

Obwohl vorangegangene Ausführungsbeispiele stets Torsionsfedern zeigen, welche einen Mikrospiegel mit Aktuatoren verbinden, können prinzipiell auch andere Elemente an den, den Aktuatoren abgewandten, Enden der Torsionsfeder angeordnet werden, beispielsweise Linsen oder Teile von elektronischen Schaltern.

## Patentansprüche

1. Vorrichtung mit
einem über gekrümmte Federelemente (14; 14a-d) schwingfähig aufgehängten optischen Element (12); und
mindestens zwei jeweils einseitig fest gelagerten Aktuatoren (16a; 16b), die über die gekrümmten Federelemente (14; 14a-d) mit dem schwingfähig aufgehängten optischen Element (12) verbunden sind, um das schwingfähig aufgehängte optische Element (12) in Schwingung zu versetzen;
wobei die Federelemente zumindest einen und weniger als zehn alternierenden Vorzeichenwechsel des Krümmungsradius (r_{K1}; r_{K2}) entlang des Verlaufs der Längsmittellinie aufweisen; und wobei ein Vorzeichenwechsel einem auf einer alternierenden Seite zu einem benachbarten Krümmungsmittelpunkt (34, 35) angeordneten Krümmungsmittelpunkt (34, 35) entspricht.

2. Vorrichtung gemäß Anspruch 1, bei dem die Federelemente über einen lokalen Krümmungsradius (r_{K1}; r_{K2}) gekrümmt sind, wobei jedes gekrümmte Federelement (14; 14a-d) so geformt ist, dass sich die Krümmungsradien (r_{K1}; r_{K2}) kontinuierlich entlang des Verlaufs der Federelemente (14; 14a-d) ändern.

3. Vorrichtung gemäß Anspruch 1 oder 2, wobei die Aktuatoren (16a; 16b) symmetrisch um eine Torsionsachse (18) des schwingfähig aufgehängten optischen Elementes (12) angeordnet sind.

4. Vorrichtung gemäß einem der vorangehenden Ansprüche, wobei die Aktuatoren (16a; 16b) symmetrisch um eine Symmetrieachse (41), die senkrecht zur Torsionsachse (18) des schwingfähig aufgehängten optischen Elementes steht (12), angeordnet sind.

5. Vorrichtung gemäß einem der vorangehenden Ansprüche, wobei jeder Aktuator (16a; 16b) ein Piezoelement umfasst.

6. Vorrichtung gemäß einem der vorangehenden Ansprüche, wobei eine Abmessung jedes Aktuators (16a; 16b) von einem Ort einer festen Lagerung des jeweiligen Aktuators (16a; 16b) zu einem Befestigungsort an dem der jeweilige Aktuator (16a; 16b) mit einem der gekrümmten Federelemente (14; 14a-d) verbunden ist, größer ist als die Hälfte der längsten Abmessung des schwingfähig aufgehängten optischen Elementes (12) und die längste Abmessung die größte Entfernung zweier Punkte des optischen Elementes (12) ist.

7. Vorrichtung gemäß einem der vorangehenden Ansprüche, wobei Befestigungsorte (22a-d), an denen die Aktuatoren (16a; 16b) mit den gekrümmten Federelementen verbunden sind, auf zwei Linien (26a; 26b) liegen und symmetrisch zu einer Torsionsachse (18) verlaufen.

8. Vorrichtung gemäß einem der vorangehenden Ansprüche, wobei die Federelemente (14; 14a-d) beabstandet von einer Torsionsachse (18) des schwingfähig aufgehängten optischen Elementes (12) mit selbigem verbunden sind.

9. Vorrichtung gemäß einem der vorangehenden Ansprüche, wobei die Vorrichtung ein zusätzliches Federelement (36a; 36b) aufweist, das mit dem schwingfähig aufgehängten optischen Element (12) an einer Torsionsachse (18) desselben verbunden und frei von direkten Verbindungen zu den gekrümmten Federelementen (14; 14a-d) ist.

10. Vorrichtung gemäß einem der vorangehenden Ansprüche, bei der ein erstes Federelement (14; 14a-d) und ein zweites Federelement (14; 14a-d) einen gemeinsamen Bereich (38a-b) umfassen.

11. Vorrichtung gemäß einem der vorangehenden Ansprüche, wobei jedes gekrümmte Federelement (14; 14a-d) so geformt ist, dass der Verlauf der lokalen Orientierung entlang einer Längsmittellinie (32) einen stetigen Verlauf aufweist.

## Claims

1. A device comprising:
an optical element (12) suspended to be vibratable via curved spring elements (14; 14a-d); and
at least two actuators (16a; 16b), each mounted fixedly on one side, which are connected to the vibratably suspended optical element (12) via the curved spring elements (14; 14a-d) to cause the vibratably suspended optical element (12) to vibrate;
wherein the spring elements comprise at least one and less than ten alternating changes in sign of the radius of curvature (r_{K1}; r_{K2}) along the course of the longitudinal center line; and wherein a change in sign corresponds to a center of curvature (34, 35) arranged on an alternating side relative to an adjacent center of curvature (34, 35).

2. The device in accordance with claim 1, wherein the spring elements are curved at a local radius of curvature (r_{K1}; r_{K2}), wherein each curved spring element (14; 14a-d) is shaped such that the radii of curvature (r_{K1}; r_{K2}) change continuously along the course of the spring elements (14; 14a-d).

3. The device in accordance with claim 1 or 2, wherein the actuators (16a; 16b) are arranged to be symmetrical around a torsion axis (18) of the vibratably suspended optical element (12).

4. The device in accordance with any of the preceding claims, wherein the actuators (16a; 16b) are arranged to be symmetrical around an axis of symmetry (41) which is perpendicular to the torsion axis (18) of the vibratably suspended optical element (12).

5. The device in accordance with any of the preceding claims, wherein each actuator (16a; 16b) includes a piezo-element.

6. The device in accordance with any of the preceding claims, wherein a dimension of each actuator (16a; 16b) from a place of fixed support of the respective actuator (16a; 16b) to a mounting place where the respective actuator (16a; 16b) is connected to one of the curved spring elements (14; 14a-d) is greater than half of the longest dimension of the vibratably suspended optical element (12) and the longest dimension is the largest distance between two points of the optical element (12).

7. The device in accordance with any of the preceding claims, wherein mounting places (22a-d) where the actuators (16a; 16b) are connected to the curved spring elements are located on two lines (26a; 26b) and are symmetrical to a torsion axis (18).

8. The device in accordance with any of the preceding claims, wherein the spring elements (14; 14a-d) are connected to the vibratably suspended optical element (12) in a manner spaced apart from a torsion axis (18) thereof.

9. The device in accordance with any of the preceding claims, wherein the device comprises an additional spring element (36a; 36b) which is connected to the vibratably suspended optical element (12) at a torsion axis (18) thereof and is free of direct connections to the curved spring elements (14; 14a-d).

10. The device in accordance with any of the preceding claims, wherein a first spring element (14; 14a-d) and a second spring element (14; 14a-d) comprise a common region (38a-b).

11. The device in accordance with any of the preceding claims, wherein each curved spring element (14; 14a-d) is shaped such that the local orientation along a longitudinal center line (32) is of a continuous course.

## Revendications

1. Dispositif avec
un élément optique (12) suspendu de manière pivotante par l'intermédiaire d'éléments ressorts courbés (14; 14a à d); et
au moins deux actionneurs (16a; 16b) montés fixes chacun d'un côté qui sont connectés par l'intermédiaire des éléments ressorts courbés (14; 14a à d) à l'élément optique (12) suspendu de manière pivotante, pour faire pivoter l'élément optique (12) suspendu de manière pivotante;
dans lequel les éléments ressorts présentent au moins un et moins de dix changements de signe alternants du rayon de courbure (rₖ₁, rₖ₂); et dans lequel un changement de signe correspond à un point central de courbure (34, 35) disposé d'un côté alternatif à un point central de courbure (34, 35) adjacent.

2. Dispositif selon la revendication 1, dans lequel les éléments ressorts sont courbés selon un rayon de courbure local (rₖ₁, rₖ₂), chaque élément ressort courbé (14; 14a à d) étant formé de sorte que les rayons de courbure (rₖ₁, rₖ₂) varient en continu le long de l'extension des éléments ressorts (14; 14a à d).

3. Dispositif selon la revendication 1 ou 2, dans lequel les actionneurs (16a, 16b) sont disposés de manière symétrique autour d'un axe de torsion (18) de l'élément optique suspendu de manière pivotante (12).

4. Dispositif selon l'une des revendications précédentes, dans lequel les actionneurs (16a, 16b) sont disposés de manière symétrique autour d'un axe de symétrie (41) qui est perpendiculaire à l'axe de torsion (18) de l'élément optique suspendu de manière pivotante (12).

5. Dispositif selon l'une des revendications précédentes, dans lequel chaque actionneur (16a; 16b) comporte un élément piézo-électrique.

6. Dispositif selon l'une des revendications précédentes, dans lequel une dimension de chaque actionneur (16a; 16b) d'un endroit d'un montage fixe de l'actionneur respectif (16a; 16b) à un endroit de fixation auquel l'actionneur respectif (16a; 16b) est connecté par l'un des éléments ressorts courbés (14; 14a à d) est supérieure à la moitié de la dimension la plus longue de l'élément optique suspendu de manière pivotante (12) et la dimension la plus longue est la distance la plus grande entre deux points de l'élément optique (12).

7. Dispositif selon l'une des revendications précédentes, dans lequel les endroits de montage (22a à d) auxquels les actionneurs (16a; 16b) sont connectés aux éléments ressorts courbés se situent sur deux lignes (26a, 26b) et s'étendent de manière symétrique par rapport à un axe de torsion (18).

8. Dispositif selon l'une des revendications précédentes, dans lequel les éléments ressorts (14; 14a à d) sont connectés espacés d'un axe de torsion (18) de l'élément optique suspendu de manière pivotante (12) à ce dernier.

9. Dispositif selon l'une des revendications précédentes, dans lequel le dispositif présente un élément ressort additionnel (36a; 36b) qui est connecté avec l'élément optique suspendu de manière pivotante (12) à un axe de torsion (18) de ce dernier et est exempt de connexions directes avec les éléments ressorts courbés (14; 14a à d).

10. Dispositif selon l'une des revendications précédentes, dans lequel un premier élément ressort (14; 14a à d) et un deuxième élément ressort (14; 14a à d) comportent une région commune (38a-b).

11. Dispositif selon l'une des revendications précédentes, dans lequel chaque élément ressort courbé (14; 14a à d) est formé de sorte que l'évolution de l'orientation locale le long d'une ligne centrale longitudinale (32) présente une extension continue.
